# EUROPEAN PATENT APPLICATION

(11) **EP 4 517 815 A1**
(43) Date of publication of application: **05.03.2025**
(21) Application number: 23795841.8
(22) Date of filing: 06.02.2023
(51) Int. Cl.: H01L 23/473

(54) **HEAT EXCHANGER**

(30) Priority: 28.04.2022 JP 2022074169
(71) Applicant: Nikkeikin Almo Company, Ltd., Tokyo 105-8681 (JP)
(72) Inventor: SEKI, Kazuhito, Shizuoka-shi, Shizuoka 421-3297 (JP); ENDO, Masanori, Shizuoka-shi, Shizuoka 421-3291 (JP); HIRAI, Tomoki, Shizuoka-shi, Shizuoka 421-3291 (JP); NISHIKORI, Yusuke, Shizuoka-shi, Shizuoka 421-3291 (JP); KIKUCHI, Yuichi, Shizuoka-shi, Shizuoka 421-3297 (JP); ASANUMA, Satoshi, Tokyo 105-8681 (JP); KANEKO, Takumi, Tokyo 105-8681 (JP)
(74) Representative: TBK
(86) International application number: PCT/JP2023/003737
(87) International publication number: WO 2023/210093

(57) **Abstract**

To provide a heat exchanger in which a joint between an aluminum member and a synthetic resin member may be maintained even when the heat exchanger is subjected to a shearing load or operated under high temperature so as to ensure liquid-tightness and heat resistance. The heat exchanger comprises: a heat exchanging box 10 formed of synthetic resin having a flow passage 11 for flowing liquid refrigerant; and a lid 20 formed of aluminum that closes an opening 10a of the heat exchanging box 10 to be in contact with an exothermic member 30 including a thermoelectric element. The heat exchanging box 10 comprises a joint surface 15a formed around an opening edge of the opening 10a, and a positioning wall 16 for positioning the lid 20 formed around the joint surface. The lid 20 is attached to the heat exchanging box 10 by fusing the joint surface 15a of the heat exchanging box 10 to an uneven joint surface 22 formed on a joint area 21 of the lid 20.

## Description

### Technical Field

The present invention relates to a heat exchanger, and more specifically, to a heat exchanger in which an aluminum member is joined to a resin member.

### Background Art

Heat exchangers for cooling an exothermic member by flowing liquid cooling medium through flow passages are well known in the art. The heat exchanger of this kind comprises a bottomed-container member in which flow passage are formed (hereinafter referred to as the cooling box), and a lid member that closes an opening of the cooling box. The cooling box is formed of synthetic resin, and the lid member is formed of aluminum. In the heat exchanger of this kind, the lid member is joined to the cooling box by applying adhesive such as epoxy resin to an opening edge of the cooling box and pushing the lid member onto the cooling box while heating. Otherwise, the lid member is joined to the cooling box by applying a laminate sheet having an inner heat fusion layer to an opening edge of the cooling box and fixing the lid member to the opening edge of the cooling box by a heat-sealing method (c.f., publication of Japanese Patent No. 6534024).

According to the teachings of Japanese Patent No. 6534024, the heat exchanger may be thinned and lightened, and the heat exchanger described therein may be attached to e.g., a surface of a heat generating power conductor having a semiconductor element to cool the power conductor by cooling medium held in the cooling box.

In the prior art, there is also known a heat exchanger for cooling or heating a thermoelectric element that converts heat directly into electric energy through a thermoelectric effect, e.g., a Peltier device that absorbs or generates heat by an electric current (c.f., Japanese Patent laid-open No. 2021-23439).

According to the teachings of Japanese Patent laid-open No. 2021-23439, a heat-conducting plate formed of copper is attached to a cooling block formed of synthetic resin so that flow passages formed in the cooling block are insulated.

In the heat exchanger of this kind, the cooling block is filled with a liquid cooling medium. Therefore, it is necessary to ensure liquid-tightness and rigidity of the cooling block. In addition, the heat-conducting plate is attached to the cooling block while heating, and a temperature of the cooling medium will be raised in a case of using the heat exchanger of this kind as a heater. Therefore, it is also necessary to ensure heat resistance property of the heat exchanger of this kind.

### Summary of Invention

### Technical Problem to be Solved by the Invention

As described, in the heat exchanger described in the publication of Japanese Patent No. 6534024, the lid member is thermally joined to the opening edge of the cooling box through the epoxy adhesive or the laminate sheet having the heat fusion layer. However, if the adhesive or the heat fusion layer is thermally affected by the heat when joining the lid member to the cooling box, the lid member would be detached from the opening edge of the cooling box by a shearing load applied to a joint area between the lid member and the cooling box. Consequently, the liquid-tightness and the rigidity of the heat exchanger may be reduced. The adhesive or the heat fusion layer is also thermally affected by the cooling medium in a situation where a temperature of the cooling medium is raised. In this situation, the lid member may also be detached from the opening edge of the cooling box thereby reducing the liquid-tightness and the rigidity of the heat exchanger. Whereas, Japanese Patent laid-open No. 2021-23439 is silent about how to attach the heat-conducting plate formed of copper to the cooling block formed of synthetic resin. That is, a rigidity of the joint area between the heat-conducting plate and the cooling block, as well as a liquid-tightness and a heat resistance of the heat exchanger may not be improved by the teachings of Japanese Patent laid-open No. 2021-23439.

The present invention has been conceived noting the foregoing technical problems, and it is therefore an object of the present invention to provide a heat exchanger in which a joint between an aluminum member and a synthetic resin member may be maintained even when the heat exchanger is subjected to a shearing load or operated under high temperature so as to ensure the liquid-tightness and the heat resistance of the heat exchanger.

### Means for Solving the Problem

According to the present invention, there is provided a heat exchanger comprising: a heat exchanging box formed of synthetic resin having a flow passage for flowing liquid refrigerant; and a lid formed of aluminum that closes an opening of the heat exchanging box to be in contact with an exothermic member including a thermoelectric element. In order to achieve the above-explained objectives, the heat exchanging box is provided with a joint surface formed around an opening edge of the opening, and a positioning wall for positioning the lid that is formed around the joint surface. In addition, the lid is attached to the heat exchanging box by fusing the joint surface of the heat exchanging box to an uneven joint surface formed on a joint area of the lid.

According to the above-explained configuration, therefore, the joint surface of the heat exchanging box may be fused to the uneven joint surface formed on the joint area of the lid while positioning the lid by the positioning wall.

According to the present invention, the uneven joint surface may be formed by forming at least one score line by laser in a parallel manner all along the joint area of the lid.

According to the above-explained configuration, therefore, the heat exchanging box may be fixed homogeneously and tightly to the lid.

According to the present invention, the heat exchanging box may be further provided with a partition wall that divides the opening to form a flow passage between a refrigerant inlet and a refrigerant outlet.

According to the above-explained configuration, therefore, an inner surface of the lid that is not fixed to the heat exchanging box may be supported by the partition wall even if the heat exchanging box is deformed and a thickness of the heat exchanging box is reduced as a result of dielectric heating.

### Advantageous Effects of Invention

Since the present invention is configured as has been described, the following advantages may be achieved.
(1) According to claim 1 of the present invention, the joint surface of the heat exchanging box is fused to the uneven joint surface formed on the joint area of the lid while supporting the lid by the positioning wall. Therefore, the lid may be attached firmly to the heat exchanging box without misalignment. For this reason, connection between the lid and the heat exchanging box may be maintained firmly even when the heat exchanger is subjected to a shearing load or even when the heat exchanger is operated under high temperature. In other words, a liquid-tightness and a heat resistance of the heat exchanger may be enhanced.
(2) According to claim 2 of the present invention, the heat exchanging box may be fixed homogeneously and tightly to the lid. Therefore, in addition to the advantage of claim 1, connection between the lid and the heat exchanging box may be maintained more certainly even when the heat exchanger is subjected to a shearing load or even when the heat exchanger is operated under high temperature. That is, the liquid-tightness and the heat resistance of the heat exchanger may be further enhanced.
(3) According to claim 3 of the present invention, the inner surface of the lid that is not fixed to the heat exchanging box may be supported by the partition wall even if the heat exchanging box is deformed and a thickness of the heat exchanging box is reduced as a result of dielectric heating. Therefore, a flatness of a heat exchanging surface of the lid may be maintained to improve a heat exchanging efficiency.

### Brief Description of Drawings

[Fig. 1] (a) is a cross-sectional view schematically showing a cross-section of the heat exchanger according to the present invention, (b) is a cross-sectional view showing a cross-section of the heat exchanger along the I-I line drawn in Fig. 1 (a), and (c) is a partial cross-sectional view showing a cross-section of the section II shown in Fig. 1 (b) in an enlarged scale.
[Fig. 2] is a perspective view showing a cross-section of a part of the heat exchanging box according to the present invention in which the heat exchanging box is closed by the lid.
[Fig. 3] is an exploded perspective view showing the heat exchanging box and the lid member according to the present invention.
[Fig. 3A] (a) to (e) are plan views showing patterns of the uneven joint surface according to the present invention.
[Fig. 4] is a perspective view showing the heat exchanger according to the present invention.
[Fig. 5] (a) is a front view of the heat exchanging box, (b) is a right side view of the heat exchanging box, (c) is a plan view of the heat exchanging box, and (d) is a bottom plan view of the heat exchanging box.
[Fig. 6] is a cross-sectional view along the III-III line drawn in Fig. 5 (c).
[Fig. 7] is a cross-sectional view along the IV-IV line drawn in Fig. 5 (c).
[Fig. 8] is a perspective view showing a mold used to assemble the heat exchanger according to the present invention.
[Fig. 9] is a perspective view showing the mold on which the heat exchanging box closed by the lid member is placed.

### Description of Embodiment(s)

Hereinafter, an exemplary embodiment of the heat exchanger for heating and cooling an exothermic member according to the present invention will be described in detail with reference to the accompanying drawings.

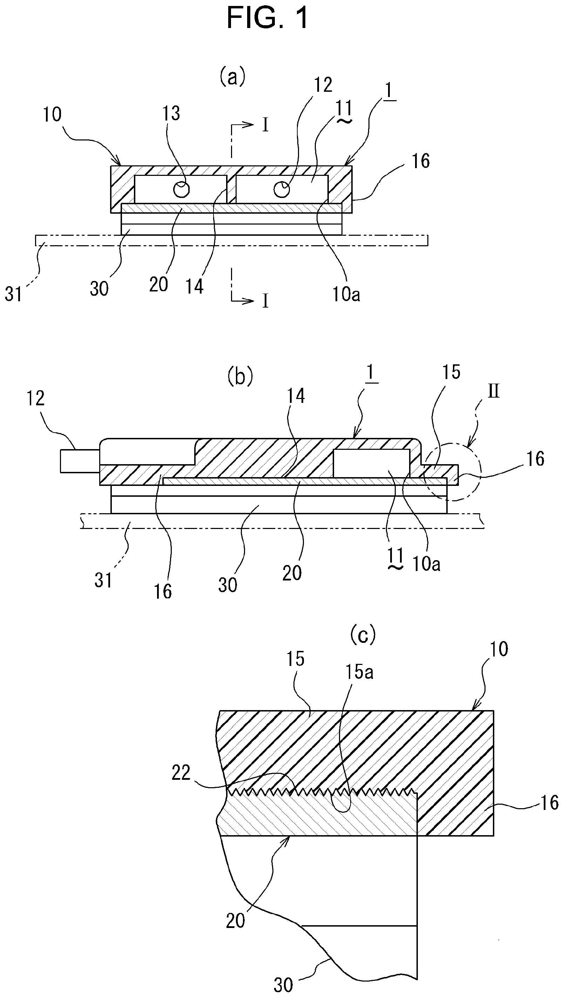

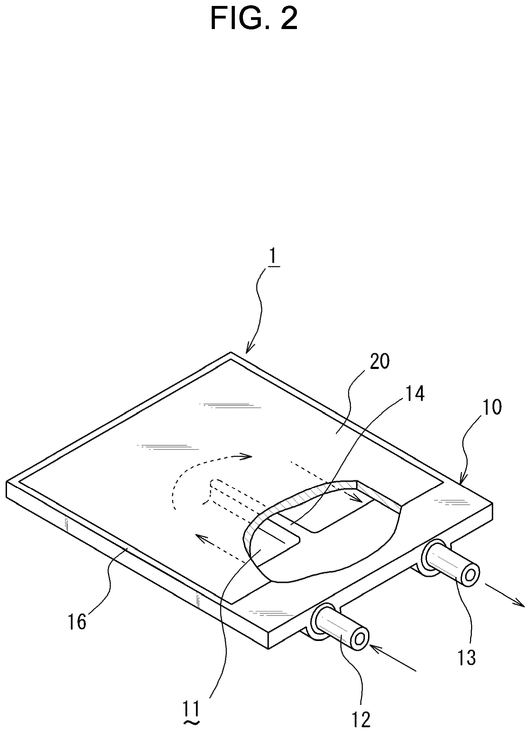

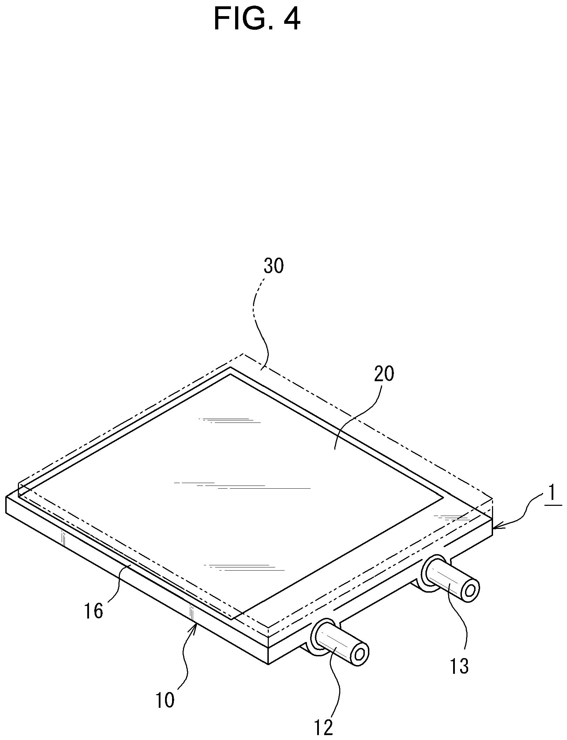

As illustrated in Figs. 1, 2, and 4, a heat exchanger 1 according to the present invention comprises: a heat exchanging box 10 formed of thermoplastic synthetic resin having a flow passage 11 for flowing liquid refrigerant (e.g., solution of pure water and ethylene glycol); and a lid 20 formed of aluminum (including aluminum alloy) that closes an opening 10a of the heat exchanging box 10 to be in contact with an exothermic member including a thermoelectric element such as a Peltier element 30.

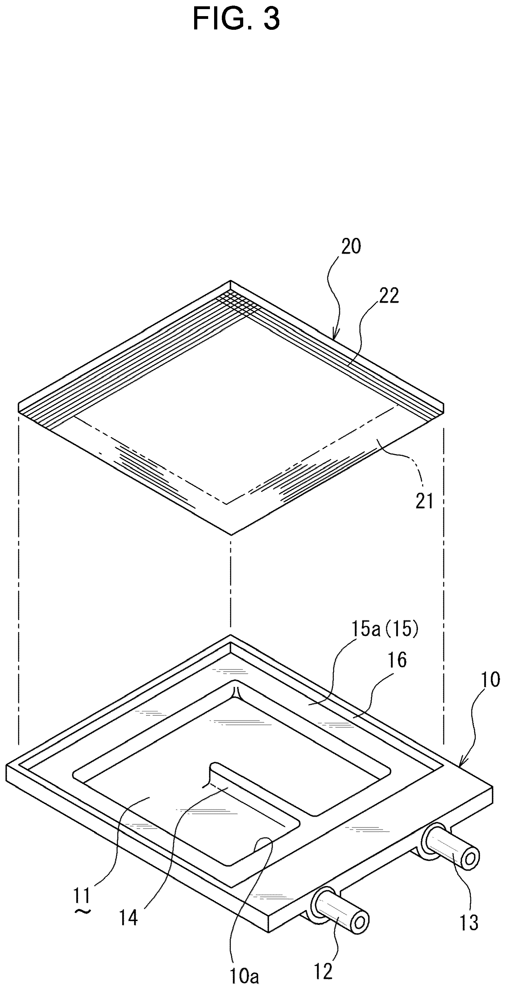

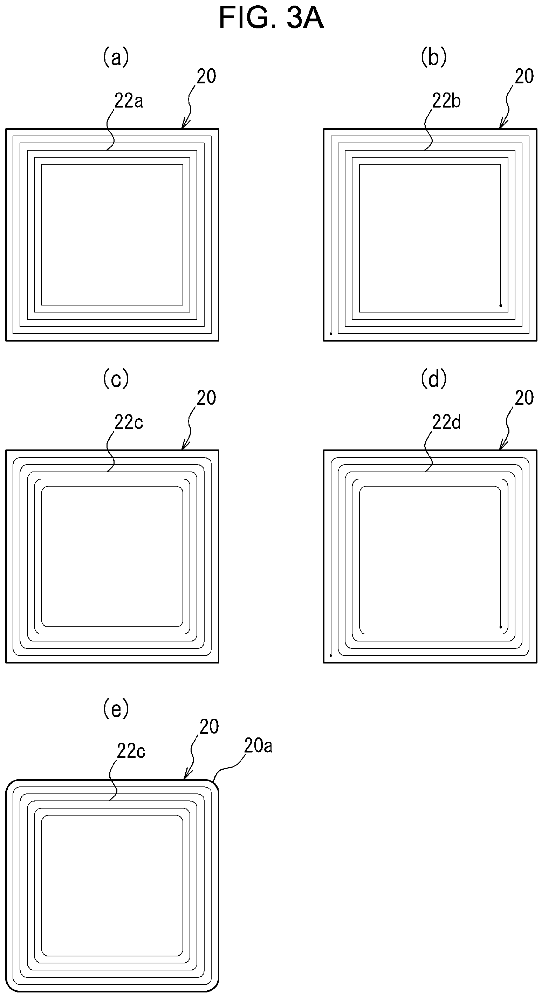

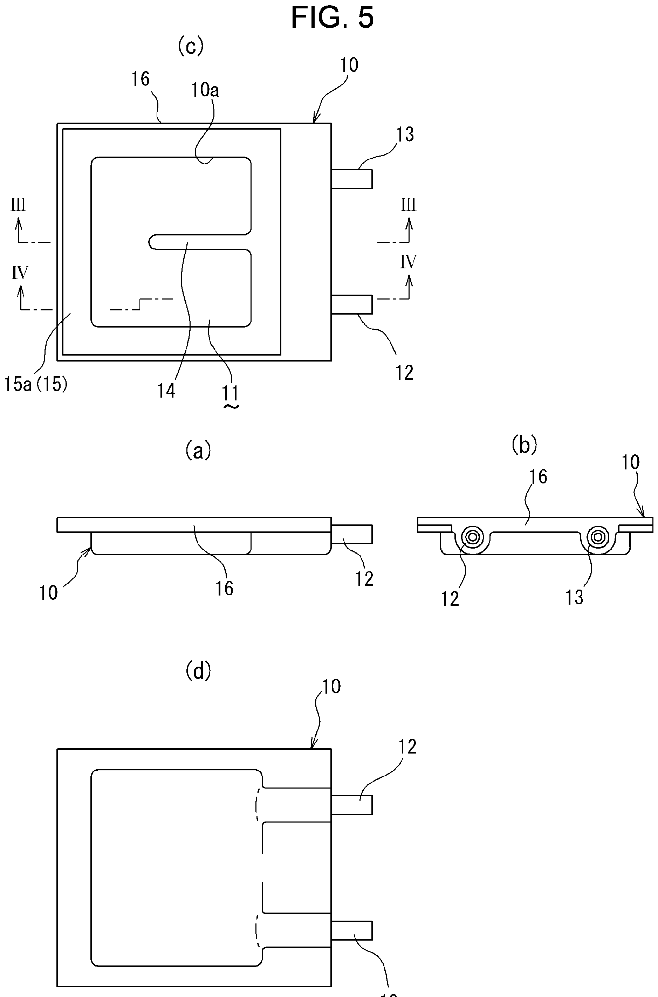

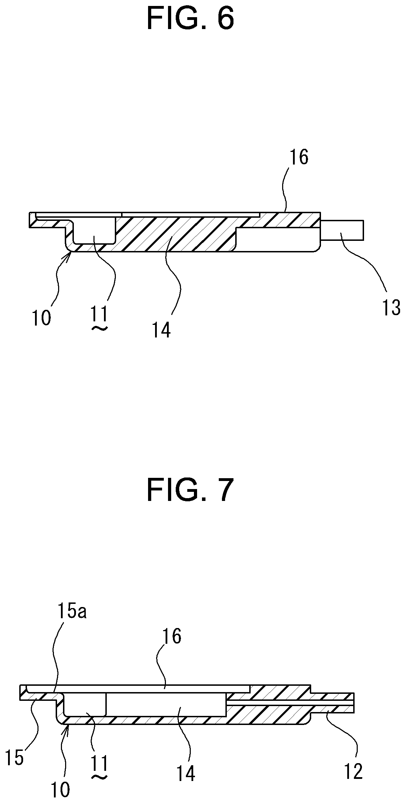

The heat exchanging box 10 is formed of thermoplastic resin such as ABS resin. As illustrated in Figs. 3, and 5 to 7, the heat exchanging box 10 is a truncated cuboid member including a rectangular opening 10a, a joint surface 15a formed around an opening edge of the opening 10a, and a positioning wall 16 for positioning the lid 20 that is formed around the joint surface 15a. Specifically, the joint surface 15a is formed on an upper surface of a flange section 15 expanding around the opening 10a of the heat exchanging box 10, and the positioning wall 16 is formed around the flange section 15.

The heat exchanging box 10 further includes a refrigerant inlet 12 and a refrigerant outlet 13 formed on one side of the heat exchanging box 10, and an inner space of the opening 10a is divided by a partition wall 14 so that a flow passage 11 is formed between the refrigerant inlet 12 and the refrigerant outlet 13. Specifically, an upper surface of the partition wall 14 is aligned with the joint surface 15a.

The lid 20 is a rectangular plate member, and a peripheral surface of the lid 20 is supported by the positioning wall 16 formed in the heat exchanging box 10. In the lid 20, an uneven joint surface 22 is formed on a joint area 21 to be joined with the joint surface 15a of the heat exchanging box 10. For example, the uneven joint surface 22 may be formed by forming at least one score line by laser in a parallel manner all along the joint area 21 of the lid 20 (c.f., Figs. 1 (c) and 3).

In the example shown in Fig. 3, a plurality of the score lines is formed on each side of the joint area 21 (by laser so that the uneven joint surface 22 is depressed alternately), and the score lines are crossed at each corner of the lid 20. However, the uneven joint surface 22 should not be limited to the foregoing example. Modifications of the uneven joint surface 22 are shown in Figs. 3A (a) to (e). In the example shown in Fig. 3A (a), a plurality of square score lines are formed concentrically to form an uneven joint surface 22a. In the example shown in Fig. 3A (b), a score line is formed into a square spiral to form an uneven joint surface 22b. In the example shown in Fig. 3A(c), a plurality of rounded-square score lines are formed concentrically to form an uneven joint surface 22c. In the example shown in Fig. 3A (d), a score line is formed into a rounded-square spiral to form an uneven joint surface 22d. In addition, in the case of forming the score line(s) into a rounded-square shape, each corner 20a of the lid 20 may also be rounded (c.f., Fig. 3A (c)).

In the case of forming the score line(s) into the square shape, the rounded-square shape, the square spiral, or the rounded-square spiral, the score line(s) is/are not extended to the outer circumferential edge of the lid 20.

In the case of forming the score line(s) in the patterns shown in Fig. 3A, therefore, leakage of the refrigerant from the corners of the lid 20 may be reduced compared to the case in which the score lines are crossed at each corner of the lid 20. That is, given that the score lines are crossed at the corner of the lid 20, void spaces are created at the corner and in the vicinity of the corner thereby inducing the leakage of the refrigerant from the corner. In addition, given that the score lines reach the outer circumferential edge of the lid 20, the refrigerant may leak from openings formed on the outer circumferential edge of the lid 20. Whereas, given that the score line(s) is/are formed into the square shape, the rounded-square shape, the square spiral, or the rounded-square spiral, the score line(s) is/are not extended to the outer circumferential edge of the lid 20. In those cases, therefore, the openings are not formed on the outer circumferential edge of the lid 20 and the leakage of the refrigerant may be prevented.

The lid 20 having the above-explained structure is attached to the heat exchanging box 10 by fusing the joint surface 15a of the heat exchanging box 10 to the uneven joint surface 22, 22a, 22b, 22c, or 22e formed on the joint area 21 of the lid 20.

For example, the lid 20 made of aluminum may be attached to the heat exchanging box 10 made of thermoplastic resin by a high-frequency dielectric heating method. In this case, the heat exchanging box 10 serves as a dielectric material, and the heat exchanging box 10 is heated by means of a dielectric loss induced by subjecting the heat exchanging box 10 to a high-frequency electromagnetic field. Specifically, polar molecules contained in the heat exchanging box 10 are rotated continuously at a high speed by applying a voltage to the heat exchanging box 10. Consequently, the heat exchanging box 10 is heated by the heat induced by the collision and friction of the molecules.

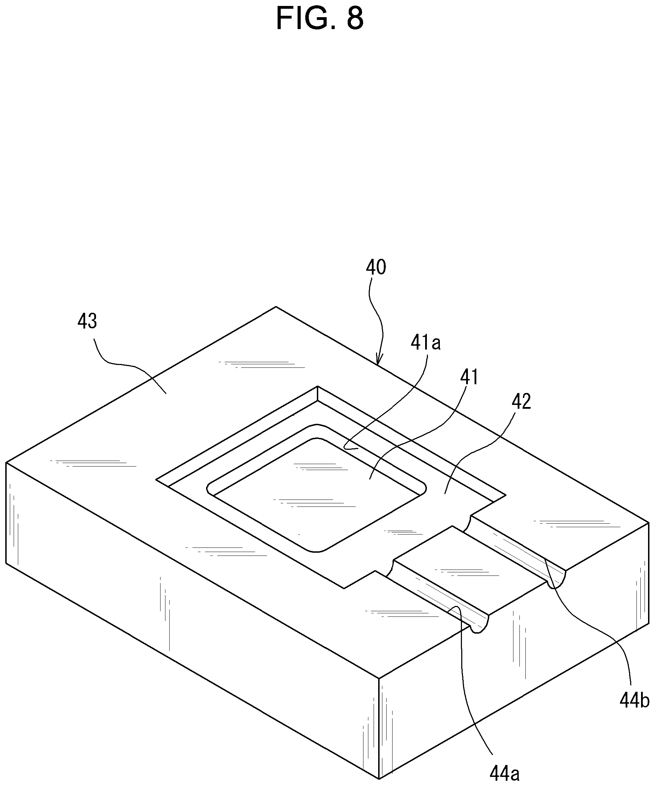

Thus, the lid 20 is fused to the heat exchanging box 10 by subjecting the heat exchanging box 10 to a high-frequency electromagnetic field while applying a constant pressure to the heat exchanging box 10. However, edges of the lid 20 may be expanded and the heat exchanging box 10 may be warped. In order to prevent such expansion of the lid 20 and warpage of the heat exchanging box 10, the lid 20 is attached to the heat exchanging box 10 by the dielectric heating method using a mold 40 shown in Fig. 8.

As illustrated in Fig. 8, the mold 40 is a cuboid body made of aluminum comprising; a lower recess 41 on which the flow passage 11 of the heat exchanging box 10 is placed; an upper recess 42 on which the flange section 15 of the heat exchanging box 10 is placed around an opening 41a of the lower recess 41; a top surface 43 formed around the upper recess 42; a semi-circular groove 44a on which the cylindrical refrigerant inlet 12 is placed; and a semi-circular groove 44b on which the cylindrical refrigerant inlet 13 is placed. Specifically, the semi-circular groove 44a has an arcuate cross-section, and extends on the top surface 43 from one side of the upper recess 42. Likewise, the semi-circular groove 44b also has an arcuate cross-section, and also extends on the top surface 43 from said one side of the upper recess 42.

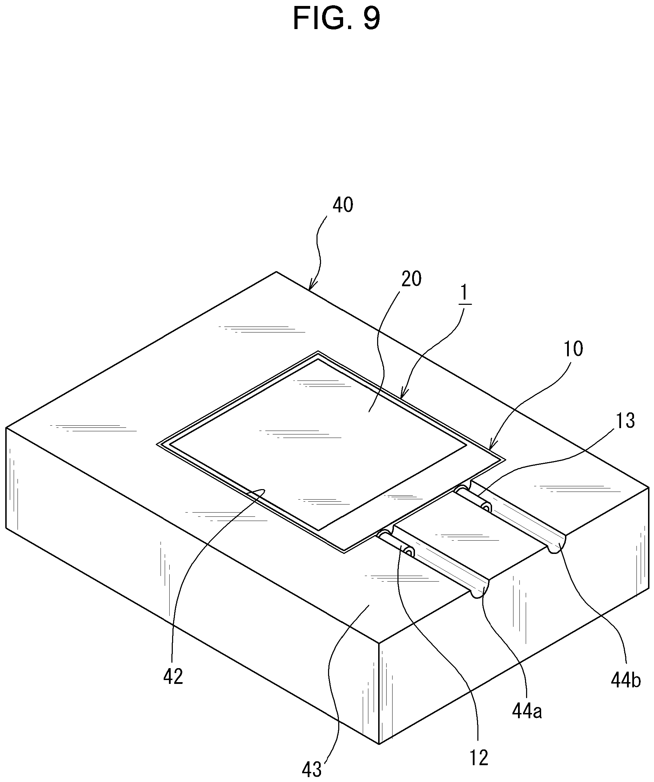

As illustrated in Fig. 9, in order to attach the lid 20 to the heat exchanging box 10, the heat exchanging box 10 is fitted into the mold 40 so that the flow passage 11 is placed on the lower recess 41 of the mold 40 and the flange section 15 is placed on the upper recess 42, and the lid 20 is placed on the joint surface 15a so that the uneven joint surface 22 is brought into contact with the joint surface 15a. The heat exchanging box 10 thus fitted into the mold 40 and the lid 20 placed on the heat exchanging box 10 are then subjected to dielectric heating. Consequently, the heat exchanging box 10 is fused to be brought into semi-liquid phase so that the joint surface 15a thereof is engaged tightly with the uneven joint surface 22 of the lid 20. Thereafter, the heat exchanging box 10 and the lid 20 are cooled so that the lid 20 is fixed to the heat exchanging box 10 (c.f., Fig. 1 (c)).

In the heat exchanger 1 formed by thus attaching the lid 20 to the heat exchanging box 10, an outer surface of the lid 20 is brought into contact with the Peltier element 30 to be in use. For example, the heat exchanger 1 may be used to cool or warm a skin of human being. In a case of using the heat exchanger 1 to cool human skin, a voltage is applied to the Peltier element 30 thereby cooling a plate 31 (shown in Fig. 1) which is in contact with an endothermic side of the Peltier element 30. In this case, the lid 20 which is also in contact with the Peltier element 30 generates heat, and the lid 20 generating heat is cooled by the refrigerant flowing through the flow passage 11 of the heat exchanging box 10. Whereas, in a case of using the heat exchanger 1 to warm human skin, a voltage is applied to the Peltier element 30 thereby heating the plate 31. In this case, the lid 20 which is also in contact with the Peltier element 30 is cooled, and the lid 20 being cooled is warmed by the refrigerant flowing through the flow passage 11 of the heat exchanging box 10.

Although the Peltier element 30 is employed as an exothermic member in the foregoing embodiment, the present invention may also be applied to heat exchanges for cooling an exothermic member other than the Peltier element such as a semiconductor element.

In addition, although the lid 20 is attached to the heat exchanging box 10 by the high-frequency dielectric heating in the foregoing embodiment, the lid 20 may also be attached to the heat exchanging box 10 by other methods such as ultrasonic welding. In this case, the heat exchanging box 10 is fused to the lid 20 by a heat induced by applying ultrasonic vibrations and load to a contact site between the lid 20 and the heat exchanging box 10.

Thus, according to the embodiment of the present invention, the lid 20 is supported by the positioning wall 16, and the joint surface 15a of the heat exchanging box 10 is fused to the uneven joint surface 22, 22a, 22b, 22c, or 22e formed on the joint area 21 of the lid 20. Therefore, the lid 20 may be attached firmly to the heat exchanging box 10 without misalignment. For this reason, connection between the lid 20 and the heat exchanging box 10 may be maintained firmly even when the heat exchanger 1 is subjected to a shearing load or even when the heat exchanger 1 is operated under high temperature. In other words, a liquid-tightness and a heat resistance of the heat exchanger 1 may be enhanced.

In addition, since the lid 20 is attached to the heat exchanging box 10 by dielectric heating in the mold 40, expansion of the lid 20 and warpage of the heat exchanging box 10 may be prevented.

Moreover, in the uneven joint surface 22, 22a, 22b, 22c, or 22e of the lid 20, the score line(s) is/are formed in a parallel manner within the joint area 21. Therefore, the joint surface 15a of the heat exchanging box 10 may be fixed homogeneously and tightly to the joint area 21 of the lid 20.

Furthermore, even if the heat exchanging box 10 is deformed and a thickness of the heat exchanging box 10 is reduced as a result of dielectric heating, the inner surface of the lid 20 that is not fixed to the heat exchanging box 10 may be supported by the partition wall 14. Therefore, a flatness of a heat exchanging surface of the lid 20 may be maintained to improve a heat exchanging efficiency.

## Claims

1. A heat exchanger, comprising:
a heat exchanging box formed of synthetic resin having a flow passage for flowing liquid refrigerant; and
a lid formed of aluminum that closes an opening of the heat exchanging box to be in contact with an exothermic member including a thermoelectric element,
**characterized in that**:
the heat exchanging box comprises a joint surface formed around an opening edge of the opening, and a positioning wall for positioning the lid that is formed around the joint surface; and
the lid is attached to the heat exchanging box by fusing the joint surface of the heat exchanging box to an uneven joint surface formed on a joint area of the lid.

2. The heat exchanger as claimed in claim 1, wherein the uneven joint surface is formed by forming at least one score line by laser in a parallel manner all along the joint area of the lid.

3. The heat exchanger as claimed in claim 1 or 2, wherein the heat exchanging box further comprises a partition wall that divides the opening to form a flow passage between a refrigerant inlet and a refrigerant outlet.
